# EUROPÄISCHE PATENTSCHRIFT

(11) **EP 0 819 783 B1**
(45) Veröffentlichungstag und Bekanntmachung des Hinweises auf die Patenterteilung: **20.09.2000**
(21) Anmeldenummer: 97111715.5
(22) Anmeldetag: 10.07.1997
(51) Int. Cl.: C30B 15/00, C30B 15/14

(54) **Verfahren und Vorrichtung zur Herstellung eines Einkristalls**
Process and apparatus for producing a single crystal
Procédé et appareillage pour préparer un monocristal

(30) Priorität: 17.07.1996 DE 19628851
(43) Veröffentlichungstag der Anmeldung: 21.01.1998
(73) Patentinhaber: Wacker Siltronic Gesellschaft für Halbleitermaterialien Aktiengesellschaft, 84489 Burghausen (DE)
(72) Erfinder: Nemetz, Friedrich, 5270 Mauerkirchen (AT)
(74) Vertreter: Rimböck, Karl-Heinz, Dr.

(56) Entgegenhaltungen:
- EP-A- 0 568 183
- EP-A- 0 608 875
- EP-A- 0 715 005
- PATENT ABSTRACTS OF JAPAN vol. 10, no. 362 (C-389) [2419] , 4.Dezember 1986 & JP 61 158890 A (FUJITSU LTD), 18.Juli 1986,

## Beschreibung

Gegenstand der Erfindung ist ein Verfahren zur Herstellung eines Einkristalls aus Silicium in einer inertgasgespülten Ziehkammer durch Ziehen des Einkristalls aus einer Schmelze nach der Czochralski-Methode. Gegenstand der Erfindung ist auch eine Vorrichtung zur Durchführung des Verfahrens.

Bei der Herstellung von Einkristallen aus Silicium nach der Czochralski-Methode ist es üblich, die Ziehkammer mit Inertgas zu spülen, während ein Einkristall aus der, in einem Tiegel liegenden Schmelze gezogen wird. Die Spülung mit Inertgas verhindert, daß Partikel aus dem Gasraum der Ziehkammer zur Phasengrenze gelangen können, an der der Einkristall wächst. Es besteht nämlich die Gefahr, daß Partikel in den Kristall eingelagert werden, Versetzungen verursachen und das einkristalline Wachstum zum Erliegen bringen. Die Spülung mit Inertgas beeinflußt auch den Umfang, in dem Sauerstoff in den wachsenden Einkristall eingebaut wird. Das Inertgas wirkt als Trägergas, das Siliciumoxid aus der Schmelze aufnimmt und aus der Ziehkammer transportiert. Siliciumoxid entsteht bei der Reaktion des Schmelzenmaterials mit der Wand des üblicherweise verwendeten Quarztiegels und gast zu einem großen Teil aus der Schmelze aus. Das in der Schmelze verbleibende Siliciumoxid verursacht den Einbau von Sauerstoff in den Einkristall. Zwischen der Menge an Siliciumoxid, die vom Inertgas aufgenommen wird und der Menge an Sauerstoff, der in den Einkristall eingebaut wird, besteht ein Zusammenhang, der zur Steuerung des Einbaus von Sauerstoff in den Einkristall genutzt wird.

Der Abtransport des Siliciumoxids mit Hilfe der Spülung mit Inertgas zieht allerdings Probleme nach sich, weil sich ein Teil des Siliciumoxids in der Ziehkammer als Feststoff niederschlägt. Schlägt sich Siliciumoxid auf der Heizvorrichtung nieder, die zum Beheizen des Tiegels gebraucht wird und üblicherweise aus Graphit besteht, bildet sich bald eine Schicht aus Siliciumcarbid aus, die die Oberfläche der Heizvorrichtung bedeckt. Diese Schicht wird mit der Zeit spröde und zu einer Quelle unerwünscher Partikel. Gleiches geschieht auch, wenn die Isolierung, die die Heizvorrichtung umgibt, mit Siliciumoxid reagiert. Hierbei kann sich zusätzlich das Isolierverhalten der Isolierung so stark ändern, daß das Ziehen eines Einkistalls nicht mehr möglich ist, weil sich die Vorraussetzungen für ein einkristallines Kristallwachstum in Bezug auf das Temperaturfeld in der Schmelze und im Einkristall nicht mehr erfüllen lassen. Es ist daher unbedingt notwendig, daß die Vorrichtung zur Herstellung von Einkristallen regelmäßig stillgelegt und gereinigt wird, und daß beschädigte Teile der Vorrichtung ersetzt werden. Solche Wartungsarbeiten sind jedoch aufwendig und mit sehr hohen Kosten verbunden.

Um die Betriebszeiten zwischen notwendigen Wartungsarbeiten zu verlängern, wird in der EP-568 183 B1 vorgeschlagen, einen Inertgasstrom durch die Ziehkammer zu leiten, wobei dieser in einem zentralen Bereich im oberen Teil der Ziehkammer durch eine Einlaßöffnung einströmt und radial nach außen zu Auslaßöffnungen strömt, die radial außerhalb der Einlaßöffnung im oberen Teil der Ziehkammer angeordnet sind.

Das auf den oberen Teil der Ziehkammer beschränkte Durchleiten des Intertgasstroms verringert die Möglichkeit, mit dem Inertgasstrom den Einbau von Sauerstoff in den Einkristall zu steuern. Auf der anderen Seite verhindert diese Maßnahme nicht, daß Siliciumoxid durch Diffusion weiterhin zu Vorrichtungsteilen in der Ziehkammer gelangen kann, die um den Tiegel herum und unterhalb des Tiegels angeordnet sind. Darüber hinaus findet im unteren Teil der Ziehkammer keine Gaskonvektion statt, so daß sich aus der Isolierung ausgasender Kohlenstoffstaub auf der Isolierung ablagert und Gasentladungen zwischen Isolierung und Heizvorrichtung begünstigt.

JP-A-61 158 890 beschreibt eine Vorrichtung mit zwei getrennt voreinander gespüllen kammern.

Die Aufgabe der Erfindung bestand darin, eine Verlängerung der Betriebszeiten zwischen zwei notwendigen Wartungsarbeiten zu erreichen, ohne dabei Nachteile insbesondere bei der Steuerung der Sauerstoffkonzentration in Kauf nehmen zu müssen.

Gelöst wird die Aufgabe durch ein Verfahren gemäß Anspruch 1.

Der Erfolg des Verfahrens zeigt sich insbesondere in einer beachtlichen Verlängerung des Intervalls zwischen zwei notwendigen Wartungszyklen. Darüber hinaus werden hohe Einsparungen erzielt, weil beispielsweise die Heizvorrichtung und die sie umgebende Isolierung weniger verschleißen und seltener erneuert werden müssen. Ein weiterer Kostenvorteil ist darin zu sehen, daß sich die Produktivität der Ziehanlage erhöht und die hergestellten Einkristalle eine gleichbleibend hohe Qualität aufweisen.

Gegenstand der Erfindung ist auch eine Vorrichtung zur Durchführung des Verfahrens.

Das Verfahren und die Vorrichtung werden nachfolgend an Hand von Figuren näher erläutert.

Figur 1 zeigt in einer schematischen Schnittdarstellung eine nicht erfindungsgemäße Vorrichtung.

Figur 2 zeigt, ebenfalls in Schnittdarstellung, eine Ausführungsform der Vorrichtung.

In beiden Figuren sind nur solche Merkmale dargestellt, die zur Erklärung der Erfindung notwendig sind. Gleichartige Merkmale sind mit gleichen Bezugsziffern versehen.

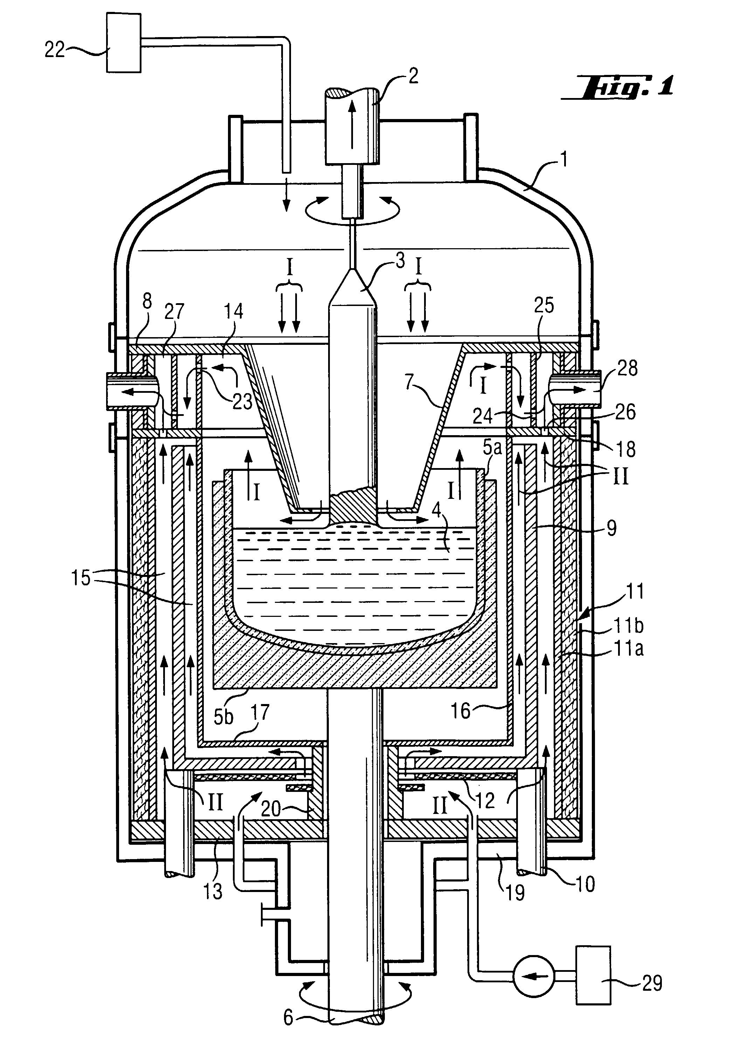

Die Vorrichtung gemäß Fig.1 umfaßt eine Ziehkammer 1 mit einer nur andeutungsweise dargestellten Einrichtung 2 zum Ziehen eines Einkristalls 3 aus einer Schmelze 4 nach der Czochralski-Methode. Die Schmelze befindet sich in einem Tiegel 5a, der üblicherweise aus Quarzglas besteht, von einem Stütztiegel 5b abgestützt wird und auf einer Welle 6 drehbar und vertikal verschiebbar gelagert ist. Zur thermischen Abschirmung des Einkristalls ist es üblich, einen Hitzeschild 7 vorzusehen, der den Einkristall umgibt und bis nahe an die Oberfläche der Schmelze heranreicht. Der Hitzeschild kann rohrförmig oder, wie es aus der Figur 1 ersichtlich ist, konusförmig ausgebildet sein. Zur Abstützung des Hitzeschilds ist im oberen Teil der Ziehanlage eine Halterung 8 vorgesehen. Um den Tiegel 5a herum und unterhalb des Tiegels ist eine Heizvorrichtung 9 angeordnet. Als Heizvorrichtung wird in der Regel ein Widerstandsheizer aus Graphit mit mindestens einer Stromzuführung 10 verwendet. Die Ziehkammer ist durch Isolierungen vor schädlicher Wärmeeinwirkung geschützt. Eine Isolierung 11 ist um die Heizvorrichtung herum angeordnet. Sie umfaßt beispielsweise ein Strahlungsrohr lla aus Graphit und eine Wicklung llb aus Graphitfilz. Weitere Isolierungen 12 und 13 befinden sich im unteren Teil der Ziehkammer 1.

In der dargestellten Ausführungsform ist der Innenraum der Ziehkammer unterhalb der Halterung 8 für den Hitzeschild 7 durch weitere Einbauten in innere Kammern unterteilt. Es gibt eine erste innere Kammer 14, in der sich der Hitzeschild 7 und der Tiegel 5a befinden und eine zweite innere Kammer 15, in der sich die Heizvorrichtung 9 befindet. Die erste innere Kammer 14 wird seitlich von einem Rohr 16 begrenzt. Weitere Begrenzungen bilden die Halterung 8 (Deckenbegrenzung der Kammer 14) und eine Trägerplatte 17 (Bodenbegrenzung der Kammer 14). Das Rohr 16 und die Trägerplatte 17 sind vorzugsweise aus Graphit gefertigt und fungieren gleichzeitig auch als Begrenzungen der zweiten inneren Kammer 15. Weitere Begrenzungen der zweiten inneren Kammer 15 bilden die Abdeckung 18 (Deckenbegrenzung der Kammer 15), die Isolierung 13 (Bodenbegrenzung der Kammer 15) sowie ein Stützrohr 20 und die Isolierung 11 (Seitenbegrenzungen der Kammer 15).

Jede der inneren Kammern 14 und 15 verfügt über eine eigene Einrichtung zum Zuführen von Inertgas. Die Einrichtung 22 zum Zuführen von Inertgas in die erste innere Kammmer 14 schickt einen Inertgasstrom I in den oberen Teil der Ziehkammer und durch die Halterung 8 und durch den Hitzeschild 7 in die erste innere Kammer 14. Der zugeführte Inertgasstrom verläßt die innere Kammer 14 durch Auslaßöffnungen 23 im Rohr 16 und durch Auslaßöffnungen 24 eines Umlenkrohrs 25. Schließlich wird das zugeführte Inertgas durch Absaugöffnungen 28 aus der Ziehkammer 1 gesaugt. Die Einrichtung 29 zum Zuführen von Inertgas in die zweite innere Kammmer 15 schickt einen Inertgasstrom II durch den Boden 19 der Ziehkammer 1 und die Isolierung 13 in die zweite innere Kammer 15. Der zugeführte Inertgasstrom verläßt die innere Kammer 15 durch Auslaßöffnungen 26 in der Abdeckung 18 und wird ebenfalls durch die Absaugöffnungen 28 aus der Ziehkammer 1 gesaugt.

Die Inertgasströme können sich frühestens nach dem Verlassen der inneren Kammern 14 und 15 vermischen. In der gezeigten Ausführungsform geschieht dies in einer Absaugkammer 27, die mit den Absaugöffnungen 28 in Verbindung steht. Die vorgestellte Konstruktion der Vorrichtung schließt aus, daß der Inertgasstrom I, der mit Siliciumoxid befrachtet ist, insbesondere zur Heizvorrichtung 9 und zur Isolierung 11 gelangen kann. Andererseits verhindert der Inertgasstrom II, daß sich auf der Isolierung 11 Ablagerungen bilden und damit das Risiko elektrischer Überschläge steigt.

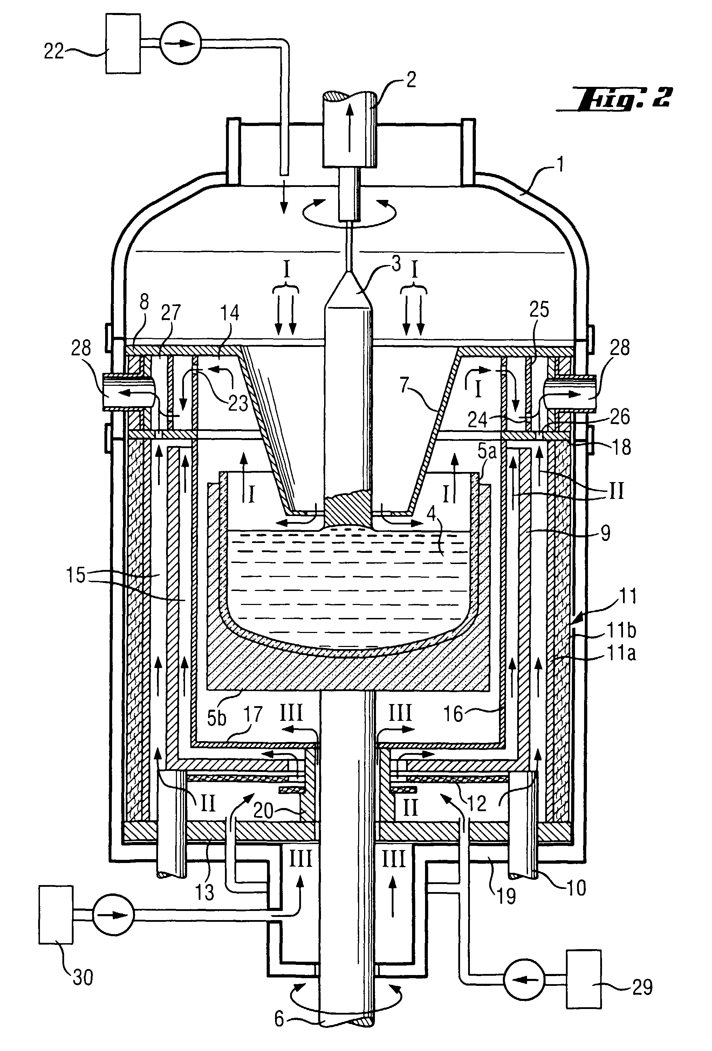

Die Figur 2 zeigt eine Ausführungsform der Erfindung, die sich von der Vorrichtung, auf die sich die Fig. 1 bezieht, durch ein zusätzliches Merkmal unterscheidet. Die Vorrichtung weist eine dritte Einrichtung 30 zum Zuführen von Inertgas auf, die einen Inertgasstrom III durch die Trägerplatte 17 in die erste innere Kammer 14 schickt. Der zugeführte Inertgasstrom III verläßt die innere Kammer 14 durch die Auslaßöffnungen 23 im Rohr 16 sowie durch die Auslaßöffnungen 24 im Umlenkrohr 25 und wird durch die Absaugöffnungen 28 aus der Ziehkammer 1 gesaugt. Die Inertgasströme I und III vermischen sich bereits in der inneren Kammer 14.

Bei dieser Ausführungsform wird der Einbau von Sauerstoff in den Einkristall nicht nur durch die Zuführung des Inertgasstroms I, sondern auch durch die Zuführung des Inertgasstroms III beeinflußt. Eine wichtige Variable, durch die der Einbau von Sauerstoff gesteuert werden kann, ist die Menge an Inertgas, die pro Zeiteinheit über die Inertgasströme I und III durch die innere Kammer 14 geleitet wird. Sie muß während des Ziehens des Einkristalls kontrolliert verändert werden, damit eine bestimmte Sauerstoff-Konzentration im Einkristall erreicht wird. In der Regel soll die Sauerstoff-Konzentration im Einkristall einen gewünschten, engen Wertebereich nicht über-oder unterschreiten.

Damit die gewünschte Sauerstoff-Konzentration im Einkristall tatsächlich erreicht wird, wird in Vorversuchen ermittelt, in welchem Verhältnis die Inertgasströme I und III Inertgas in die innere Kammer zuführen müssen, und geklärt, wie sich das Verhältnis während des Wachstums des Einkristalls ändern muß. Falls auf einen dritten Inertgasstrom verzichtet wird, ist die Menge an Inertgas maßgebend, die pro Zeiteinheit durch den Inertgasstrom I in die innere Kammer 14 gelangt und die zeitliche Änderung dieser Menge.

Der Vergleich der Betriebszeiten zwischen notwendigen Wartungsarbeiten aufgrund eines Verschleißes der Heizvorrichtung oder der sie umgebenden Isolierung ergab, daß eine Vorrichtung gemäß Fig. 1 unter vergleichbaren Ziehbedingungen ungefähr fünfmal länger zu betreiben war, als eine gleichartige Vorrichtung bekannter Bauart.

## Patentansprüche

1. Verfahren zur Herstellung eines Einkristalls aus Silicium in einer inertgasgespülten Ziehkammer durch Ziehen des Einkristalls aus einer Schmelze nach der Czochralski-Methode, wobei in der Ziehkammer eine erste innere Kammer und eine zweite innere Kammer bereitgestellt werden, von denen jede durch Seiten-, Decken-, und Bodenbegrenzungen begrenzt ist, wobei
a) ein erster Inertgasstrom durch die Deckenbegrenzung der ersten inneren Kammer in erste innere Kammer geführt wird, in der sich ein Hitzeschild, der um den Einkristall herum angeordnet ist, und ein Tiegel mit der Schmelze befinden;
b) ein zweiter Inertgasstrom durch die Bodenbegrenzung der zweiten inneren Kammer in die zweite innere Kammer geführt wird, in der sich eine Heizvorrichtung zum Beheizen des Tiegels befindet, mit der Maßgabe, daß sich der erste und der zweite Inertgasstrom erst frühestens nach dem Verlassen der inneren Kammern vermischen können; und
c) ein dritter Inertgasstrom durch die Bodenbegrenzung der ersten inneren Kammer in die erste innere Kammer geführt wird.

2. Verfahren nach Anspruch 1, dadurch gekennzeichnet, daß die Zuführung des ersten und des dritten Inertgasstroms der Steuerung des Einbaus von Sauerstoff in den Einkristall dient.

3. Vorrichtung zur Herstellung eines Einkristalls aus Silicium nach der Czochralski-Methode, umfassend eine inertgasgespülte Ziehkammer mit einer Einrichtung zum Ziehen des Einkristalls aus einer Schmelze und mit
a) einem Tiegel zur Aufnahme der Schmelze;
b) einer Heizvorrichtung zum Beheizen des Tiegels, die um den Tiegel herum angeordnet ist;
c) einer Isolierung, die um die Heizvorrichtung herum angeordnet ist;
d) einem Hitzeschild, der über der Schmelze um den Einkristall herum angeordnet ist;
e) einer ersten inneren Kammer, in der sich der Tiegel und der Hitzeschild befinden und eine zweite innere Kammer, in der sich die Heizvorrichtung befindet, wobei die inneren Kammern von Seiten-, Decken- und Bodenbegrenzungen begrenzt sind; wobei
f) eine erste Einrichtung zum Zuführen von Inertgas durch die Deckenbegrenzung der ersten inneren Kammer in die erste innere Kammer und eine zweite Einrichtung zum Zuführen von Inertgas durch die Bodenbegrenzung der zweiten inneren Kammer in die zweite innere Kammer und eine dritte Einrichtung zum Zuführen von Inertgas durch die Bodenbegrenzung der ersten inneren Kammer in die erste innere Kammer vorhanden sind.

## Claims

1. Method for producing a silicon single crystal in an inert-gas flushed pulling chamber by pulling the single crystal from a melt by the Czochralski method, a first inner chamber and a second inner chamber, each of which is delineated by side, top and bottom boundaries, being provided in the pulling chamber,
a) a first inert gas stream being passed through the top boundary of the first inner chamber into the first inner chamber, which contains a heat shield, which is disposed around the single crystal, and a crucible containing the melt;
b) a second inert gas stream being passed through the bottom boundary of the second inner chamber into the second inner chamber, which contains a heating device for heating the crucible, with the proviso that the first inert gas stream and the second inert gas stream are only able to mix, at the earliest, after leaving the inner chambers; and
c) a third inert gas stream being passed through the bottom boundary of the first inner chamber into the first inner chamber.

2. Method according to Claim 1, characterized in that the feeding-in of the first inert gas stream and the third inert gas stream serves to control the incorporation of oxygen into the single crystal.

3. Apparatus for producing a silicon single crystal by the Czochralski method, comprising an inert-gas flushed pulling chamber containing a device for pulling the single crystal from a melt and having
a) a crucible for receiving the melt;
b) a heating device for heating the crucible which is disposed around the crucible;
c) an insulation which is disposed around the heating device;
d) a heat shield which is disposed above the melt around the single crystal;
e) a first inner chamber, which contains the crucible and the heat shield, and a second inner chamber, which contains the heating device, the inner chambers being delineated by side, top and bottom boundaries; where
f) a first device for feeding inert gas through the top boundary of the first inner chamber into the first inner chamber and a second device for feeding inert gas through the bottom boundary of the second inner chamber into the second inner chamber and a third device for feeding inert gas through the bottom boundary of the first inner chamber into the first inner chamber are present.

## Revendications

1. Procédé pour préparer un monocristal en silicium dans une chambre d'étirage purgée à l'aide de gaz inerte, par étirage du monocristal à partir d'une masse en fusion, conformément à la méthode de Czochralski, une première chambre interne et une deuxième chambre interne, qui sont limitées chacune par des limitations latérales, de plafond et de plancher, étant mises à disposition dans la chambre d'étirage,
a) un premier courant de gaz inerte étant conduit par la limitation de plafond de la première chambre interne dans la première chambre interne, dans laquelle se trouvent un écran antichaleur, qui est disposé tout autour du cristal, et un creuset avec la masse en fusion ;
b) un deuxième courant de gaz inerte étant conduit par la limitation de plancher de la deuxième chambre interne dans la deuxième chambre interne, dans laquelle se trouve, en vue du chauffage du creuset, un dispositif de chauffage, sous réserve que le premier courant et le deuxième courant de gaz inerte puissent se mélanger au plus tôt après avoir quitté les chambres internes ; et
c) un troisième courant de gaz inerte étant conduit par la limitation de plancher de la première chambre interne dans la première chambre interne.

2. Procédé selon la revendication 1, caractérisé en ce que la conduite du premier courant et du deuxième courant de gaz inerte sert au contrôle de l'insertion d'oxygène dans le monocristal.

3. Dispositif pour préparer un monocristal en silicium conformément à la méthode de Czochralski, comprenant une chambre d'étirage purgée à l'aide de gaz inerte avec un dispositif en vue de l'étirage du monocristal à partir d'une masse en fusion et avec
a) un creuset pour la réception de la masse en fusion ;
b) un dispositif de chauffage en vue du chauffage du creuset, qui est disposé tout autour du creuset ;
c) une isolation, qui est disposée tout autour du dispositif de chauffage ;
d) un écran antichaleur, qui est disposé tout autour du monocristal au-dessus de la masse en fusion ;
e) une première chambre interne, dans laquelle se trouvent le creuset et l'écran antichaleur et une deuxième chambre interne, dans laquelle se trouve le dispositif de chauffage, les chambres internes étant limitées par des limitations latérales, de plafond et de plancher ;
f) un premier dispositif en vue de la conduite de gaz inerte à travers la limitation de plafond de la première chambre interne dans la première chambre interne et un deuxième dispositif en vue de la conduite de gaz inerte à travers la limitation de plancher de la deuxième chambre interne dans la deuxième chambre interne et un troisième dispositif en vue de la conduite de gaz inerte à travers la limitation de plancher de la première chambre interne dans la première chambre interne.
